(19) **Europäisches Patentamt / European Patent Office / Office européen des brevets**

(11) **EP 4 336 203 A1**

(12) # EUROPEAN PATENT APPLICATION

(43) Date of publication:
**13.03.2024 Bulletin 2024/11**

(21) Application number: **22197025.4**

(22) Date of filing: **22.09.2022**

(51) International Patent Classification (IPC):
*G01R 33/48* (2006.01)    *G01R 33/485* (2006.01)
*G01R 33/561* (2006.01)    *G01R 33/44* (2006.01)

(52) Cooperative Patent Classification (CPC):
**G01R 33/4824; G01R 33/4828; G01R 33/485;**
**G01R 33/5611; G01R 33/5615;** G01R 33/443

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **09.09.2022 US 202263404997 P**

(71) Applicant: **Koninklijke Philips N.V.**
**5656 AG Eindhoven (NL)**

(72) Inventors:
• **GOPALAKRISHNAN, Karthik**
  **Eindhoven (NL)**
• **VALVANO, Giuseppe**
  **Eindhoven (NL)**
• **MENON, Kannan**
  **5656AG Eindhoven (NL)**

(74) Representative: **Philips Intellectual Property &
Standards
High Tech Campus 52
5656 AG Eindhoven (NL)**

(54) ## DE-BLURRING AND WATER/FAT SEPARATION IN MR IMAGING WITH SPIRAL ACQUISITION

(57)    The invention relates to a method of MR imaging of an object (10) positioned in a main magnetic field within an examination volume of an MR device (1). It is an object of the invention to provide an improved spiral imaging technique delivering good image quality by more accurate deblurring and water/fat separation. The method of the invention comprises the following steps: subjecting the object (10) to an imaging sequence comprising at least one RF excitation pulse and modulated magnetic field gradients for generating MR signals at two or more different echo times; acquiring MR signals along a number of distinct spiral k-space trajectories (31, 32, 33), each spiral k-space trajectory (31, 32, 33) being assigned one of the two or more different echo times, wherein the MR signals are received in parallel via a set of at least two RF coils (11, 12, 13) having different spatial sensitivity profiles within the examination volume; and reconstructing an MR image from the acquired MR signals using a parallel reconstruction algorithm, wherein the MR image reconstruction is performed by solving an inverse problem based on a signal encoding model determined by the spatial sensitivity profiles of the RF coils (11, 12, 13), the k-space sampling defined by the spiral k-space trajectories (31, 32, 33), and prior known echo time-dependent phase offsets attributed to the MR signals, which at least includes phase offsets caused by chemical shift and phase offsets caused by spatial inhomogeneity of the main magnetic field. Moreover, the invention relates to an MR device (1) and to a computer program for an MR device (1).

Fig. 2

**EP 4 336 203 A1**

**Description**

FIELD OF THE INVENTION

The invention relates to the field of magnetic resonance (MR) imaging. It concerns a method of MR imaging of an object. The invention also relates to an MR device and to a computer program to be run on an MR device.

BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for imaging of soft tissue. They are also superior to other imaging methods in many respects, for example, avoiding ionizing radiation and are usually not invasive.

Spiral imaging is a fast MR imaging technique that benefits from an efficient k-space coverage and a low sensitivity to motion and flow artefacts. Spiral k-space trajectories allow for an efficient and temporally flexible sampling of k-space as shorter pathways are required to cover a desired k-space region, and the signal acquisition may start in the center of k-space. A significant SNR (signal-tonoise ratio) gain is achieved by spiral readouts over other k-space sampling schemes. Spiral imaging techniques are, however, vulnerable to inhomogeneities of the main magnetic field Bo, which causes blurring and degrades the image quality. Most known spiral off-resonance correction (de-blurring) methods proposed to date are not only difficult to apply to correct for blurring artefacts but also inefficient and impractical due to the computational complexity involved. One major reason for it has to with the difference in signal contributions from fat and water species owing to the chemical shift-induced frequency offset between them across the Field Of View (FOV). For avoiding fat-induced blurring artefacts approaches are known that separate signal contributions from fat and water protons from the acquired MR signals (so-called Dixon techniques). In this case, however, the scan time benefit of spiral imaging is reduced by the need of acquiring and reconstructing several echo signals sampling the same k-space regions at different echo times as a prerequisite for performing the Dixon separation.

EP 3 531 154 A1 describes a multi-gradient echo MR imaging technique with increased acquisition speed and intrinsic suppression of artefacts from Bo inhomogeneities, $T_2^*$ decay, chemical shift, motion, and/or flow, in particular in combination with spiral k-space trajectories. Multiple echo signals are generated at different echo times. Signal contributions from water and fat from the echo signals are separated and, simultaneously, a Bo map and/or an apparent transverse relaxation time map ($T_2^*$ map) are estimated using a Dixon technique. On this basis, an MR image of a specified contrast is synthesized from the acquired echo signal data along with the Bo map and/or the $T_2^*$ map.

SUMMARY OF THE INVENTION

From the foregoing it is readily appreciated that off resonance (Bo inhomogeneity) artefacts still remain one of the main disadvantages of spiral imaging. There is thus a need for an improved spiral imaging technique providing good image quality by more accurate de-blurring and water/fat separation.

In accordance with the invention, a method of MR imaging of an object positioned in a main magnetic field within an examination volume of an MR device is disclosed. The method comprises:

- subjecting the object to an imaging sequence comprising at least one RF excitation pulse and modulated magnetic field gradients for generating MR signals at two or more different echo times,
- acquiring MR signals along a number of distinct spiral k-space trajectories, each spiral k-space trajectory being assigned one of the two or more different echo times, wherein the MR signals are received in parallel via a set of at least two RF coils (including, e.g., a multi-channel coil) having different spatial sensitivity profiles within the examination volume, and
- reconstructing an MR image from the acquired MR signals using a parallel reconstruction algorithm, wherein the MR image reconstruction is performed by solving an inverse problem based on a signal encoding model determined by the spatial sensitivity profiles of the RF coils, the k-space sampling defined by the spiral k-space trajectories, and a-priori known echo time-dependent phase offsets attributed to the MR signals, which at least includes phase offsets caused by chemical shift and phase offsets caused by spatial inhomogeneity of the main magnetic field.

According to the invention, additional scan time for acquiring the MR signals at different echo times is avoided. The MR signals are acquired at the different echo time along spiral k-space trajectories that are all distinct from each other in k-space, meaning that no point in k-space is sampled multiple times. In a possible embodiment, the distinct spiral k-space trajectories complement each other to a sampling of k-space which is sufficient for image reconstruction. For achieving a scan time saving, the spiral k-space trajectory/trajectories assigned to each individual echo time uses a subsampling of k-space. Within the scope of the invention, a completely sampled (or even oversampled) set of k-space data may be obtained by the entirety of spiral k-space trajectories, or, in another variant, k-space may still be subsampled by the entirety of spiral k-space trajectories. In a possible practical realization, the spiral k-space trajectories can be rotated, uniquely, relative to each other with respect to the k-space center (for example by applying an angular increment corresponding to the golden angle). Hence, the spiral k-space trajectories may be interleaved with one another.

The MR signals are acquired using a parallel acquisition technique, i.e. using a set of at least two RF antennae having different spatial sensitivity profiles within the examination volume. Any incomplete sampling of k-space is compensated for by applying a corresponding parallel reconstruction algorithm. Parallel acquisition and reconstruction techniques are commonly applied for accelerating MR acquisition. Methods in this category are SENSE (Sensitivity Encoding), SMASH (Simultaneous Acquisition of Spatial Harmonics), and GRAPPA (Generalized Auto-calibrating Partially Parallel Acquisition). SENSE, SMASH, and GRAPPA and other parallel acquisition techniques use subsampled k-space data acquisition obtained from multiple RF receiving coils in parallel. The corresponding parallel reconstruction algorithms are characterized in that the (complex) MR signal data from the multiple coils are combined with complex weightings in such a way as to eliminate subsampling artifacts (aliasing) in the finally reconstructed MR images. This type of complex array signal combination is sometimes referred to as spatial filtering, and includes combining which is performed in the k-space domain (as in SMASH and GRAPPA) or in the image domain (as in SENSE), as well as methods which are hybrids.

The invention is based on the recognition that the artefacts caused by local Bo inhomogeneities and by signal contributions from fat protons (chemical shift) are best taken into account and compensated for simultaneously with the parallel image reconstruction in one computing step in order to achieve an optimal quality of the final MR image. The invention thus proposes to accommodate the de-blurring with the parallel image reconstruction. De-blurring and parallel image reconstruction is conventionally performed in separate steps leading to an unsatisfactory image quality. It is an insight of the invention that there is an interplay between (Bo inhomogeneity and chemical shift-induced) phase offsets and parallel imaging principles, especially in combination with longer MR signal readouts (as in spiral MR imaging). This interplay tends to be non-intuitive and is identified by the invention as the cause of the hitherto inadequate image quality.

Hence, according to the invention, the MR image is reconstructed from the acquired MR signals using a parallel reconstruction algorithm, wherein the MR image reconstruction is performed by solving an inverse problem based on a signal encoding model determined by the spatial sensitivity profiles of the RF coils, the k-space sampling defined by the spiral k-space trajectories, and prior known echo time-dependent phase offsets attributed to the MR signals, which at least include phase offsets caused by chemical shift and phase offsets caused by spatial inhomogeneity of the main magnetic field. The phase offsets are taken into account by additionally incorporating the corresponding phase information into the encoding matrix on which the parallel reconstruction algorithm is based. In other words, the inverse problem of image reconstruction is solved according to the invention using an encoding matrix in which the matrix elements are determined not only by the spatial sensitivity profiles of the RF coils and the k-space sampling pattern of each shot of the imaging sequence but also by the different phase offsets attributed to the MR signals. Therein, the method of the invention exploits prior knowledge of the chemical shift of fat protons relative to water protons as well as prior knowledge of Bo inhomogeneity. The latter may be obtained by including the step of acquiring a main magnetic field map into the method of the invention (e.g. as a Bo mapping pre-scan) from which the phase offsets caused by spatial inhomogeneity of the main magnetic field can be directly derived and used in the reconstruction step.

The reconstruction of the MR image from the acquired MR signals may combine parallel imaging principles with the known Compressed Sensing (CS) framework thus allowing for additional subsampling and scan time savings.

In a possible embodiment, the MR signals are acquired along the two or more spiral k-space trajectories after a single RF excitation pulse. This corresponds to a single-shot implementation of the method of the invention. The two or more spiral k-space trajectories are acquired instantly after each other, following a single RF excitation. In terms of scanning efficiency, this embodiment of the invention is thus identical to conventional single-shot spiral imaging approaches. Alternatively, the imaging sequence of the method of the invention can be a multi-shot sequence which entails that only a subset of k-space is sampled in each shot (i.e. after each RF excitation). In all implementations, the MR signals may be acquired as spin echo or gradient echo signals.

The method of the invention described thus far can be carried out by means of an MR device including at least one main magnet coil for generating a uniform static magnetic field within an examination volume, a number of gradient coils for generating switched magnetic field gradients in different spatial directions within the examination volume, at least one RF coil for generating RF pulses within the examination volume and a set of at least two RF coils having different spatial sensitivity profiles within the examination volume for receiving MR signals from an object positioned in the examination volume, a control unit for controlling the temporal succession of RF pulses and switched magnetic field gradients, and a reconstruction unit for reconstructing an MR image from the received MR signals. Alternately, the same RF coil unit can be used to transmit and receive the MR signals. The method of the invention can be implemented, for example, by a corresponding programming of the reconstruction unit and/or the control unit of the MR device.

The method of the invention can be advantageously carried out in most MR devices in clinical use at present. To this end it is merely necessary to utilize a computer program by which the MR device is controlled such that it performs the above-explained method steps of the invention. The computer program may be present either on a data carrier or be present in a data network so as to be downloaded for installation in the control unit of the MR device.

BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:

Fig. 1    shows an MR device for carrying out the method of the invention;
Fig. 2    shows diagrams of k-space illustrating the spiral sampling approach of the invention.

DETAILED DESCRIPTION OF THE EMBODIMENTS

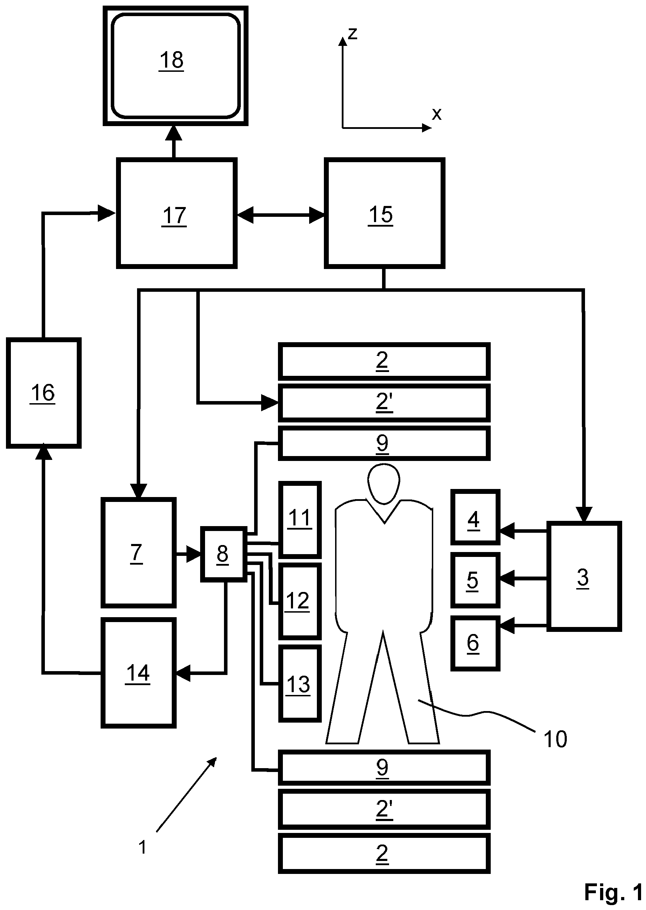

With reference to Fig. 1, an MR device 1 is schematically shown. The device comprises superconducting or resistive main magnet coils such that a substantially uniform, temporally constant main magnetic field is created along a z-axis through an examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send-/receive switch 8, to a whole-body volume RF coil 9 to transmit RF pulses into the examination volume. A typical MR imaging sequence is composed of a packet of RF pulse segments of short duration which taken together with each other and any applied magnetic field gradients achieves a selected manipulation of nuclear spins. The RF pulses are used to saturate, excite resonance, invert magnetization, refocus resonance, or manipulate resonance and select a portion of a body 10 positioned in the examination volume. The MR signals are also picked up by the whole-body volume RF coil 9.

For generation of MR images of limited regions of the body 10, a set of local array RF coils 11, 12, 13 are placed contiguous to the region selected for imaging. The array coils 11, 12, 13 can be used to receive MR signals induced by body-coil RF transmissions.

The resultant MR signals are picked up by the whole body volume RF coil 9 and/or by the array RF coils 11, 12, 13 and demodulated by a receiver 14 preferably including a preamplifier (not shown). The receiver 14 is connected to the RF coils 9, 11, 12 and 13 via send-/receive switch 8.

A host computer 15 controls the gradient pulse amplifier 3 and the transmitter 7 to generate any of a plurality of MR imaging sequences, such as gradient and spin echo imaging, fast spin echo (TSE) imaging, and the like to acquire the MR signals along spiral k-space trajectories according to the invention. For the selected sequence, the receiver 14 receives a single or a plurality of MR data along the respective k-space trajectories in rapid succession following each RF excitation pulse. A data acquisition system 16 performs analog-to-digital conversion of the received signals and converts each MR signal to a digital format suitable for further processing. In modern MR devices the data acquisition system 16 is a separate computer which is specialized in acquisition and processing of raw image data.

Ultimately, the digital raw image data is reconstructed into an image representation by a reconstruction processor 17 which applies an appropriate reconstruction algorithm. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

The MR device 1 is arranged, e.g. by appropriate programming of the host computer 15 and the reconstruction processor 17, to perform the imaging method of the invention as described herein above and in the following.

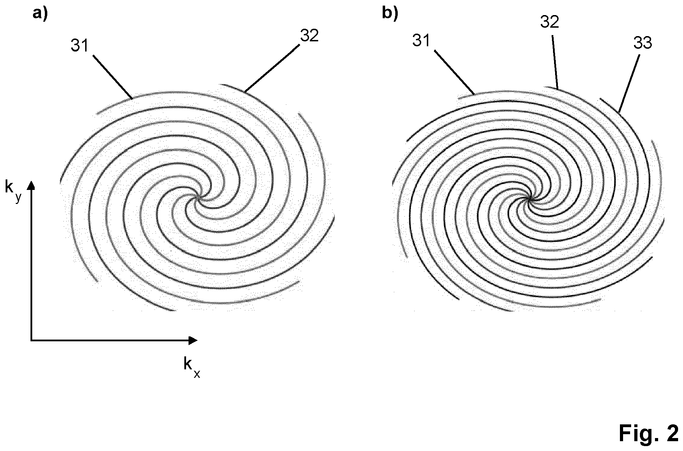

With continuing reference to Fig, 1 and with further reference to Fig. 2, an embodiment of the imaging approach of the invention is explained.

Fig. 2 illustrates the spiral acquisition strategy of the invention. The invention proposes to apply two or more spiral k-space trajectories 31, 32, 33 (eight in Fig. 2a and twelve in Fig. 2b) wherein each spiral k-space trajectory 31, 32, 33 is assigned one of two or more different echo times TE1, TE2, TE3. Each spiral arm shown in Fig. 2 is acquired as one MR echo signal, wherein the trajectory of each echo is rotated from echo to echo by an angle offset depending on the total number of spiral arms.

According to the conventional parallel imaging scheme, the acquisition is performed using a set of RF receiving coils 11, 12, 13 having different spatial sensitivity profiles. If, as in Fig. 2a, for example, MR signals at two echo times are to be acquired with an acceleration factor of two, the spiral k-space trajectories 32 of the second echoes are rotated by an angle equal to half of the rotation angle between two consecutive spiral arms 31. This concept can be generalized to an arbitrary number of echoes. An example is shown in Fig. 2b for three echoes with three spiral arms 31, 32, 33 for each echo time TE1, TE2, TE3.

In an alternative embodiment (not depicted), the rotation angle of consecutively acquired spiral arms can be incremented by the golden angle.

A saving of scan time can be achieved by using subsampled spiral k-space trajectories 31, 32, 33 for each echo. Additionally, scan time can also be saved by combining the Dixon echoes as a part of the same acquisition. In Figure 2, echo time TE1, TE2 and TE3 can be chosen optimally to guarantee water-fat separation. As illustrated in Fig. 2, the spiral k-space trajectories are all distinct (different from each other), wherein the spiral arms 31, 32, 33 complement each other to a complete (full) sampling of k-space by the entirety of k-space trajectories 31, 32, 33. Already this is different from conventional (Dixon-based) approaches which require an MR image reconstruction individually for each echo time before combining the MR signal data into a final image.

In the presence of Bo inhomogeneities and chemical shift (of fat protons), the MR signals acquired along the different spiral k-space trajectories 31, 32, 33 will accumulate different amounts of phase offsets. According to the invention, the resulting blurring artefacts are taken into account and compensated for simultaneously with the parallel image reconstruction in one computing step. To this end, the MR image reconstruction can be performed by solving an inverse problem based, for the exemplary case of two echo times and two spin populations constituted by water protons and fat protons, on the following signal encoding model:

$$\begin{bmatrix} m_1 \\ m_2 \end{bmatrix} = \begin{bmatrix} \Psi_w F_{B_1} S \Phi_{w,1} p_w + \Psi_f F_{B_1} S \Phi_{f,1} p_f \\ \Psi_w F_{B_2} S \Phi_{w,2} p_w + \Psi_f F_{B_2} S \Phi_{f,2} p_f \end{bmatrix} = E \begin{bmatrix} p_w \\ p_f \end{bmatrix}$$

Where:

$m_j$ (j=1,2) is the acquired (multi coil) MR signal in k-space for the $j^{th}$ echo time.

$p_k$(k=w,f) are the MR images (unknown) corresponding to the $k^{th}$ spin population (water/fat).

$\Phi_{k,j}$ is an image-based phasor representing the phase evolution of the $k^{th}$ spin population at the $j^{th}$ echo. This depends on the prior knowledge of the Bo map (a Bo mapping scan may be performed in a separate step as a part of the method of the invention), for each spin population $\Phi_{k,j} = \mu_{k,j} \Phi_{jj}$ applies, where $\mu_k$ is a scalar phasor representing the phase accrued during the time between the echoes (e.g., $\mu_{k,j}$ = 1 ∀ j for on resonance of water proton spins and the corresponding off resonance value of fat proton spins). The dependence of this term on k can be avoided by introducing $\mu_{k,j}$ into the formula above, or by embedding it in any of the other matrix terms (as it is a scalar).

S represents the (known) encoding by the spatial sensitivity profiles (sensitivity maps) of the used RF receiving coils, the sensitivity maps may be determined in a prior calibration step, if required.

$F_{Bj}$ represents the combination of the blurring operator and the non-Cartesian (spiral) encoding for the $j^{th}$ echo. This can be implemented in several ways, for example by using a timesegmented non-uniform fast Fourier transform (NUFFT) operator, the subscript $j$ indicates that the operator depends on the echo time since different spiral k-space trajectories are used for the different echo times. This also depends on the prior knowledge of the Bo map.

$\Psi_k$ represents the k-space phasor indicating the phase evolution due to the Larmor frequency of the $k^{th}$ spin population (water/fat).

It has to be noted that with proper pre-processing and choice of the resonant frequency (water or fat protons) some of the phasors can become equal to the identity matrix.

The signal encoding model can be generalized to an arbitrary number of echoes and an arbitrary number of species (spin populations) by simply accounting for them in the equation, as shown below:

$$m = \begin{bmatrix} m_1 \\ \vdots \\ m_j \\ \vdots \\ m_{Nj} \end{bmatrix} = \begin{bmatrix} \sum_{k=1...N_k} \Psi_k F_{B_1} S \Phi_{k,1} p_k \\ \vdots \\ \sum_{k=1...N_k} \Psi_k F_{B_j} S \Phi_{k,j} p_k \\ \vdots \\ \sum_{k=1...N_k} \Psi_k F_{B_{Nj}} S \Phi_{k,Nj} p_k \end{bmatrix} = E \begin{bmatrix} p_1 \\ \vdots \\ p_k \\ \vdots \\ p_{Nk} \end{bmatrix} = Ep$$

On the basis of this signal encoding model the reconstruction of image $p$ can be performed by solving the corresponding inverse problem with any of the following options (or a combination of these):

Direct or iterative inversion of the encoding matrix E,
Least squares solution:

$$\hat{p} = \arg\min_{p}\|Ep - m\|$$

Weighted least squares solution in case consistency weights *W* are known:

$$\hat{p} = \arg\min_{p}\|W(Ep - m)\|$$

Other data consistency models such as Huber fitting or least absolute deviations to handle robust least squares models (in case of inconsistencies, such as motion).

Regularization may be added in different forms:

To consider prior knowledge on the signal distribution (like in conventional SENSE regularization),
To consider prior knowledge on the signal distribution for each spin population (prior knowledge on the water and fat distribution in the FOV),
Sparsity (for example wavelet or AI priors), like in compressed sensing.
Regularization will generally be represented by the following equation:

$$\hat{p} = \arg\min_{p}\|W(Ep - m)\| + \sum_{r=1...N_R} R_r(p)$$

Where $R_r$ is regularization term with subscript pointing to the unique regularizer being used for different images generated from this framework.

As mentioned before, the discussed signal encoding model depends on the prior knowledge of the $B_0$ map (or an approximation of the same). This can be obtained by a separate $B_0$ mapping scan and then interpolating the derived Bo map to the desired geometry (this corresponds insofar to conventional de-blurring approaches).

**Claims**

1. Method of MR imaging of an object (10) positioned in a main magnetic field within an examination volume of an MR device (1), the method comprising:

    - subjecting the object (10) to an imaging sequence comprising at least one RF excitation pulse and modulated magnetic field gradients for generating MR signals at two or more different echo times,
    - acquiring MR signals along a number of distinct spiral k-space trajectories (31, 32, 33), each spiral k-space trajectory (31, 32, 33) being assigned one of the two or more different echo times, wherein the MR signals are received in parallel via a set of at least two RF coils (11, 12, 13) having different spatial sensitivity profiles within the examination volume, and
    - reconstructing an MR image from the acquired MR signals using a parallel reconstruction algorithm, wherein the MR image reconstruction is performed by solving an inverse problem based on a signal encoding model determined by the spatial sensitivity profiles of the RF coils (11, 12, 13), the k-space sampling defined by the spiral k-space trajectories (31, 32, 33), and prior known echo time-dependent phase offsets attributed to the MR signals, which at least includes phase offsets caused by chemical shift and phase offsets caused by spatial inhomogeneity of the main magnetic field.

2. Method of claim 1, wherein the imaging sequence is a multi-echo imaging sequence, wherein the MR signals are acquired along the distinct spiral k-space trajectories (31, 32, 33) after a single RF excitation pulse.

3. Method of claim 1 or 2, wherein the distinct spiral k-space trajectories (31, 32, 33) complement each other to a complete sampling of k-space.

4. Method of claim 1 or 2, wherein k-space is subsampled by the entirety of spiral k-space trajectories (31, 32, 33).

5. Method of any one of claims 1-4, wherein the spiral k-space trajectories (31, 32, 33) are rotated relative to each other with respect to the k-space center.

6. Method of any one of claims 1-5, wherein the spiral k-space trajectories (31, 32, 33) are interleaved with one another.

7. Method of any one of claims 1-6, further including the step of acquiring a main magnetic field map from which the phase offsets caused by spatial inhomogeneity of the main magnetic field are derived.

8. MR system including at least one main magnet coil (2) for generating a uniform, static magnetic field within an examination volume, a number of gradient coils (4, 5, 6) for generating switched magnetic field gradients in different spatial directions within the examination volume, at least one RF coil (9) for generating RF pulses within the examination volume and a set of at least two RF coils (11, 12, 13) having different spatial sensitivity profiles within the examination volume for receiving MR signals from an object (10) positioned in the examination volume, a control unit (15) for controlling the temporal succession of RF pulses and switched magnetic field gradients, and a reconstruction unit (17) for reconstructing an MR image from the received MR signals, wherein the MR device (1) is arranged to perform the following steps:

- subjecting the object (10) to an imaging sequence comprising at least one RF excitation pulse and modulated magnetic field gradients for generating MR signals at two or more different echo times,
- acquiring MR signals along a number of distinct spiral k-space trajectories (31, 32, 33), each spiral k-space trajectory being assigned one of the two or more different echo times, wherein the MR signals are received in parallel via the set of RF coils (11, 12, 13), and
- reconstructing an MR image from the acquired MR signals using a parallel reconstruction algorithm, wherein the MR image reconstruction is performed by solving an inverse problem based on a signal encoding model determined by the spatial sensitivity profiles of the RF coils (11, 12, 13), the k-space sampling defined by the spiral k-space trajectories (31, 32, 33), and prior known echo time-dependent phase offsets attributed to the MR signals, which at least includes phase offsets caused by chemical shift and phase offsets caused by spatial inhomogeneity of the main magnetic field.9.

Computer program to be run on an MR device, which computer program comprises instructions for:

- providing a set of MR signals received in parallel via a set of at least two RF coils (11, 12, 13) having different spatial sensitivity profiles and acquired along a number of distinct spiral k-space trajectories (31, 32, 33), each spiral k-space trajectory being assigned one of two or more different echo times, and
- reconstructing an MR image from the acquired MR signals using a parallel reconstruction algorithm, wherein the MR image reconstruction is performed by solving an inverse problem based on a signal encoding model determined by the spatial sensitivity profiles of the RF coils (11, 12, 13), the k-space sampling defined by the spiral k-space trajectories (31, 32, 33), and prior known echo time-dependent phase offsets attributed to the MR signals, which at least includes phase offsets caused by chemical shift and phase offsets caused by spatial inhomogeneity of the main magnetic field.

Fig. 1

**Fig. 2**

Europäisches
Patentamt

European
Patent Office

Office européen
des brevets

# EUROPEAN SEARCH REPORT

Application Number

**EP 22 19 7025**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BÖRNERT P. ET AL: "Fast Single Breath-hold 3D Abdominal Spiral Imaging with Water / Fat Separation and Off-resonance Correction", PROCEEDINGS OF THE INTERNATIONAL SOCIETY FOR MAGNETIC RESONANCE IN MEDICINE, 17TH SCIENTIFIC MEETING AND EXHIBITION, HONOLULU, HAWAII, USA, 18-24 APRIL 2009, vol. 17, 4 April 2009 (2009-04-04), page 2148, XP040609380, * the whole document * | 1-8 | INV. G01R33/48 G01R33/485 G01R33/561 ADD. G01R33/44 |
| X | FRANCISZEK HENNEL ET AL: "Spiral SENSE MP-RAGE using long readouts and an expanded signal model", PROCEEDINGS OF THE INTERNATIONAL SOCIETY FOR MAGNETIC RESONANCE IN MEDICINE, 25TH ANNUAL MEETING AND EXHIBITION, HONOLULU, HI, USA, 22-27 APRIL 2017, vol. 25, 5173, 7 April 2017 (2017-04-07), XP040692741, | 1,3,5-8 | |
| Y | * the whole document * | 2,4 | TECHNICAL FIELDS SEARCHED (IPC) G01R |
| X | ZHIQIANG LI ET AL: "A 2D spiral turbo-spin-echo technique", MAGNETIC RESONANCE IN MEDICINE, vol. 80, no. 5, 9 March 2018 (2018-03-09), pages 1989-1996, XP055641221, US ISSN: 0740-3194, DOI: 10.1002/mrm.27171 | 1-8 | |
| Y | * page 1990 – page 1992 * | 2 | |

-/--

The present search report has been drawn up for all claims

| Place of search | Date of completion of the search | Examiner |
|---|---|---|
| Munich | 8 May 2023 | Raguin, Guy |

EPO FORM 1503 03.82 (P04C01)

Europäisches
Patentamt

European
Patent Office

Office européen
des brevets

# EUROPEAN SEARCH REPORT

Application Number

**EP 22 19 7025**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | MORIGUCHI H. ET AL: "Spiral Dixon Techniques Using Sensitivity Encoding", PROCEEDINGS OF THE INTERNATIONAL SOCIETY FOR MAGNETIC RESONANCE IN MEDICINE, 12TH ANNUAL MEETING AND EXHIBITION, KYOTO, JAPAN, 15-21 MAY 2004, vol. 11, 1 May 2004 (2004-05-01), page 2683, XP040592624, * the whole document * | 4 | |
| A,D | EP 3 531 154 A1 (KONINKLIJKE PHILIPS NV [NL]) 28 August 2019 (2019-08-28) * paragraph [0012] - paragraphs [0021], [0038] * | 2,5,6 | |

TECHNICAL FIELDS
SEARCHED     (IPC)

The present search report has been drawn up for all claims

| Place of search | Date of completion of the search | Examiner |
|---|---|---|
| Munich | 8 May 2023 | Raguin, Guy |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 22 19 7025

This annex lists the patent family members relating to the patent documents cited in  the above-mentioned European search report.
The members are as contained in the European Patent Office EDP file on
The European Patent Office is in no way liable for these particulars which are merely given for the purpose of information.

08-05-2023

| Patent document cited in search report | | Publication date | Patent family member(s) | | Publication date |
|---|---|---|---|---|---|
| EP 3531154 | A1 | 28-08-2019 | CN 111758041 | A | 09-10-2020 |
| | | | DE 112019000927 | T5 | 26-11-2020 |
| | | | EP 3531154 | A1 | 28-08-2019 |
| | | | JP 2021514710 | A | 17-06-2021 |
| | | | US 2021096202 | A1 | 01-04-2021 |
| | | | WO 2019162198 | A1 | 29-08-2019 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3531154 A1